Europäisches Patentamt

European Patent Office

Office européen des brevets

(11) Numéro de publication: **0 353 115**
**A1**

## (12) DEMANDE DE BREVET EUROPEEN

(21) Numéro de dépôt: 89401834.0

(22) Date de dépôt: 27.06.89

(51) Int. Cl.⁵: **H 03 M 1/44**

(30) Priorité: 19.07.88 FR 8809729

(43) Date de publication de la demande:
**31.01.90 Bulletin 90/05**

(84) Etats contractants désignés:
**CH DE FR GB IT LI NL**

(71) Demandeur: **THOMSON COMPOSANTS MILITAIRES ET SPATIAUX**
**50, rue J.P. Timbaud**
**F-92400 Courbevoie (FR)**

(72) Inventeur: **Masson, Thierry**
**THOMSON-CSF**
**F-92045 Paris la Défence CEDEX 67 (FR)**

(74) Mandataire: **Guérin, Michel et al**
**THOMSON-CSF SCPI**
**F-92045 PARIS LA DEFENSE CEDEX 67 (FR)**

(54) Convertisseur analogique numérique avec correction d'erreur de gain fini.

(57) L'invention concerne un convertisseur analogique-numérique à structure en cascade à plusieurs étages identiques convertissant chacun un groupe de p bits dans l'ordre des poids décroissants.

Chaque étage comprend un convertisseur analogique-numérique partiel (CANP) recevant un signal Si d'entrée et fournissant p bits, un convertisseur numérique-analogique partiel (CNAP) reconvertissant ces p bits en signal analogique, un soustracteur (D) faisant la différence entre le signal d'entrée et les p bits reconvertis, et un amplificateur (AP) de gain $2^p$ pour remettre à l'échelle le signal différence en vue de la conversion de cette différence dans un étage suivant identique au premier.

Selon l'invention, pour tenir compte de l'erreur sur le gain $2^p$ due au fait que l'amplificateur AP est réalisé à partir d'un amplificateur opérationnel de gain fini G et non de gain infini, on prévoit que la tension de référence $V_i$ utilisée pour la conversion dans un étage est égale à la tension de référence de l'étage précédent affectée d'un coefficient de correction justement égal à l'erreur introduite. Un amplificateur de calibration utilisant un amplificateur opérationnel de même gain fini G permet d'établir automatiquement la tension de référence d'un étage à partir de celle de l'étage précédent.

$$V_i = (V_{i-1}) \frac{G}{G + 2^P + 1}$$

FIG.4

Bundesdruckerei Berlin

EP 0 353 115 A1

## Description

### CONVERTISSEUR ANALOGIQUE NUMERIQUE AVEC CORRECTION D'ERREUR DE GAIN FINI

L'invention concerne les convertisseurs analogique numérique ayant une structure à plusieurs étages en cascade, chaque étage comprenant :
- un convertisseur analogique-numérique partiel fournissant p bits de conversion,
- un convertisseur numérique-analogique partiel recevant ces p bits et les retransformant en signal analogique,
- un soustracteur effectuant la différence entre le signal appliqué à l'entrée de l'étage et le signal analogique fourni par le convertisseur numérique-analogique partiel,
- et enfin un amplificateur de gain $2^p$ amplifiant le signal de sortie du soustracteur et appliquant le signal amplifié à l'étage suivant du convertisseur analogique-numérique.

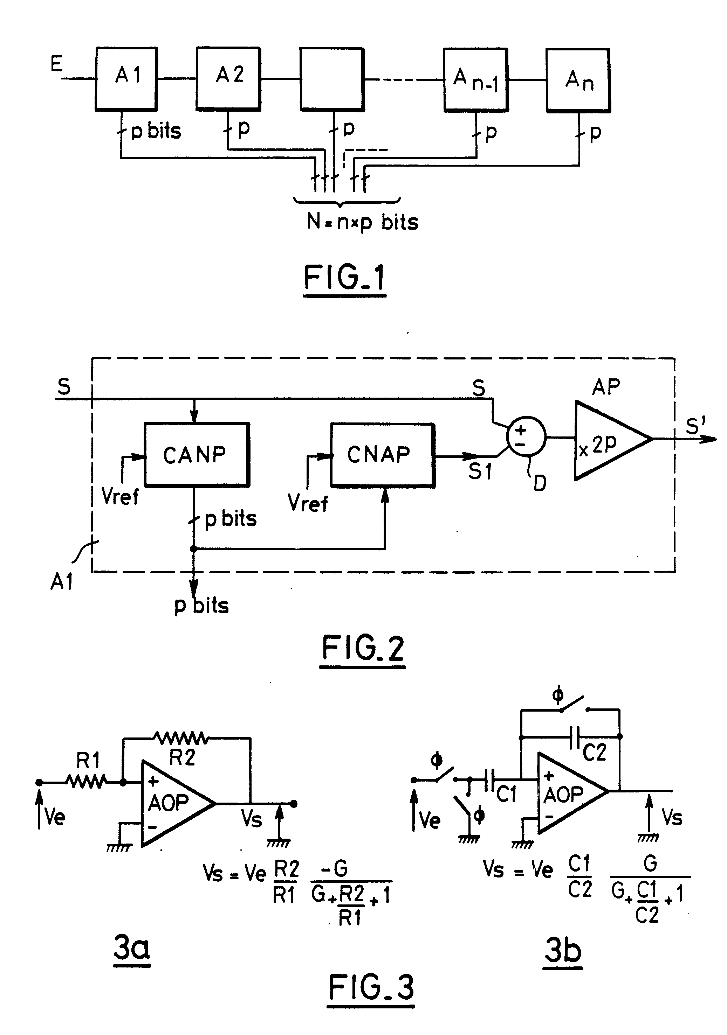

Ce type de convertisseur à structure en cascade est représenté à la figure 1 dans le cas général d'une conversion analogique-numérique à N Bits avec $N = n \times p$, c'est-à-dire avec n étages en cascade déterminant successivement les p bits de poids fort du signal (1er étage), puis les p bits immédiatement suivants (2ème étage), etc., jusqu'aux p bits de poids le plus faible ($n^{\text{ème}}$ étage).

L'entrée pour le signal analogique à convertir est désignée par E, les étages en cascade par A1, A2, etc... An-1, An. La sortie numérique est constituée par le regroupement des sorties de p bits de chacun des n étages, les poids respectifs étant décroissants dans l'ordre des étages successifs.

La structure d'un étage individuel est représentée à la figure 2, pour l'étage A1 ; les autres étages sont identiques.

Le signal analogique S à convertir est appliqué à l'entrée d'un convertisseur analogique-numérique partiel CANP à p bits (p peut être égal à 1) effectuant une conversion à partir de comparaisons avec une tension de référence Vref.

D'une part les p bits de sortie du convertisseur analogique-numérique partiel CANP constituent les sorties de poids fort du convertisseur analogique-numérique global à n étages ; d'autre part, ils sont appliqués à un convertisseur numérique analogique partiel CNAP qui fonctionne à partir de la même référence de tension Vref et qui fournit un signal analogique S′ représentant uniquement les p bits de poids fort du signal original S.

Si le signal d'entrée S peut s'exprimer sous forme
$S = k(a_1 2^N + a_2 2^{N-1} + ... a_N 2^1 + a_{N+1})$ Vref,
où $a_1$ à $a_{N+1}$ sont les N bits de la conversion analogique-numérique à effectuer, et k est une constante quelconque, alors S′ représente les p bits de poids fort de ce signal c'est-à-dire que
$S′ = k(a_1 2^N + ... + a_p 2^{N-p+1})$ Vref

Les signaux S et S′ sont appliqués aux deux entrées d'un soustracteur D qui fournit à sa sortie un signal analogique égal à la différence entre S et S′ c'est-à-dire représentant la somme pondérée des autres bits du signal original à convertir
$S-S′ = k (a_{p+1} 2^{N-p} + a_{p+2} 2^{N-p-1} + ...)$ Vref

Cette différence est appliquée à un amplificateur AP de gain $2^p$ qui fournit donc à sa sortie un signal S1 avec
$S1 = k (a_{p+1} 2^N + a_{p+2} 2^{N-1} + ...)$ Vref

Ce signal est le signal de sortie du premier étage de conversion. Il est appliqué à l'entrée de l'étage immédiatement suivant qui est rigoureusement identique au premier et qui fonctionne à partir de la même tension de référence Vref.

Il représente la différence entre le signal S d'entrée à convertir et les p bits de poids fort de ce signal, mais cette différence étant ramenée à la même échelle que le signal original S, de façon qu'elle puisse être elle-même convertie en utilisant la même tension de référence Vref et non une tension de référence Vref/$2^p$.

On comprend immédiatement que la conversion dans l'étage suivant fournira les p bits de poids immédiatement suivant $a_{p+1}$, $a_{p+2}$... $a_{2p}$ puisque S1 a pour valeur
$S1 = k (a_{p+1} 2^N + a_{p+2} 2^{N-1} + ...)$ Vref

L'amplificateur AP sert à rétablir à chaque fois le niveau du signal de sortie du soustracteur pour que la différence établie en sortie du soustracteur soit à une échelle telle qu'elle puisse être convertie à partir de la même tension Vref qui sert de référence dans tous les étages.

Ainsi, on obtient successivement, par groupes de p bits, tous les bits de la conversion analogique-numérique, avec des étages de conversion en cascade, tous identiques et utilisant une tension de référence commune pour tout le convertisseur.

Cette structure de de convertisseur analogique numérique à étages en cascade offre comme avantage principal la possibilité d'effectuer des conversions successives très rapides : on n'est pas obligé d'attendre pour commencer une conversion de signal que la conversion précédente soit terminée; il suffit que la conversion des p bits de poids fort ait eu lieu dans l'étage A1; on peut alors commencer une nouvelle conversion dans l'étage A1 pendant que les p bits de rang suivant de la première conversion sont obtenus dans l'étage A2, et ainsi de suite : le $n^{\text{ème}}$ signal à convertir peut être appliqué à l'étage A1 pendant que le $n^{\text{ème}}$ groupe de p bits du premier signal à convertir est obtenu dans l'étage An.

Cette structure, connue sous le nom de structure pipeline, fournit un débit de conversion très élevé, limité seulement par la vitesse de conversion d'un groupe de p bits dans un étage individuel. Or cette vitesse peut-être très élevée si p est un nombre petit ; des convertisseurs de quelques bits peuvent en effet être très rapides.

A titre d'exemple on peut ainsi réaliser des convertisseurs de 12 bits avec 12 étages (p = 1 bit) ou 6 étages (p = 2 bits) ou 4 étages (p = 3 bits) ou 3 étages (p = 4 bits).

Si on cherche à faire des convertisseurs de grande précision, il faut d'une part être certain que la tension de référence Vref utilisée dans les convertisseurs élémentaires analogique-numérique (AN sur la figure 2) et numérique-analogique (NA) est bien connue et contrôlée pour tous les étages, et il faut d'autre part être certain que le gain de l'amplificateur AP est bien égal à $2^p$ avec une précisions suffisante.

Si on cherche à faire des convertisseurs de grande précision, il faut d'une part être certain que la tension de référence Vref utilisée dans les convertisseurs partiels analogique-numérique (CANP sur la figure 2) et numérique-analogique (CNAP sur la figure 2) est bien connue et contrôlée pour tous les étages, et il faut d'autre part être certain que le gain de l'amplificateur AP est bien égal à $2^p$ avec une précision suffisante.

C'est pourquoi on s'arrange en général pour utiliser la même source de tension de référence Vref partout où il y a besoin d'une tension de référence ; d'autre part, on réalise l'amplificateur AP à l'aide d'un amplificateur opérationnel AOP à très grand gain intrinsèque, faible tension de décalage d'entrée, grande impédance d'entrée etc. Cet amplificateur opérationnel AOP est associé soit à des résistances (figure 3a) soit à des capacités commutées (figure 3b) selon la technologie utilisée : en technologie bipolaire on préférera des résistances dont on contrôle bien le rapport (qui définit le gain de l'amplificateur AP) ; en technologie MOS, on préférera des capacités commutées car on sait bien faire des commutateurs et des capacités dont on contrôle bien les rapports qui définissent également le gain de l'amplificateur AP.

Dans le premier cas, le gain théorique de l'amplificateur est le rapport R2/R1 (en valeur absolue) si R2 est la valeur de la résistance de rebouclage entre la sortie et l'entrée de l'amplificateur opérationnel et R1 la résistance d'entrée.

Dans le deuxième cas, le gain théorique est C1/C2 si C2 est la valeur de la capacité de rebouclage et C1 la valeur de la capacité d'entrée.

Mais ceci n'est vrai qu'en théorie et à condition de faire l'hypothèse que le gain intrinsèque de l'amplificateur opérationnel non bouclé est infini. Si le gain n'est pas infini et a une valeur G on s'aperçoit que le gain réel de l'amplificateur bouclé n'est pas R2/R1 ou C1/C2 mais
(R2/R1)G/(G + R2/R1 + 1) en valeur absolue,
ou (C1/C2)G/(G + C1/C2 + 1);
et dans le cas qui nous intéresse, le gain n'est pas $2^p$ mais
$2^p$ x G/(G + $2^p$ + 1)

Une erreur G/(G + $2^p$ + 1) est donc introduite et cette erreur affecte d'autant plus la précision de la conversion que le gain intrinsèque en boucle ouverte G est plus faible.

Par exemple, pour p = 1 et G = 1000, l'erreur est de 3 pour 1000, ce qui n'est pas acceptable pour un convertisseur à 12 bits. Elle est de 5 pour mille si p = 2 etc.

On est donc obligé d'utiliser des amplificateurs opérationnels de gain intrinsèque beaucoup plus élevé (au moins 10000) ; ils sont plus encombrants et plus lents.

Selon l'invention on propose de supprimer le problème introduit par le gain limité d'un amplificateur opérationnel d'un étage donné en utilisant comme référence de tension pour l'étage suivant du convertisseur une référence de tension dont la valeur est la valeur de référence de la conversion multipliée par erreur introduite sur le gain en boucle fermée de l'amplificateur de l'étage considéré.

Ainsi, en admettant que la tension de référence de la conversion soit Vref, c'est-à-dire que l'on cherche quels sont les bits $a_1$ à $a_N$ d'une tension analogique d'entrée S telle que
$S = k(a_1 2^N + a_2 2^{N-1} + ... a_N 2^1 + a_{N+1})$ Vref
k étant une constante généralement égale à 1, alors la tension Vref sera utilisée comme référence de conversion dans le premier étage, mais le second étage utilisera une tension de référence Vref2 qui est égale à Vref multipliée par le coefficient d'erreur G/(G + $2^p$ + 1) introduit par l'amplificateur du premier étage. Et ainsi de suite, un étage utilisera comme tension de référence de conversion la tension de référence de conversion de l'étage précédent multipliée par un coefficient K qui est l'erreur introduite par l'amplificateur de l'étage précédent.

Pour produire la référence de conversion d'un étage, on utilisera un amplificateur de calibration, de structure similaire à celle de l'amplificateur dont le gain théorique $2^p$ est affecté d'une erreur que l'on veut supprimer ; cet amplificateur de calibration utilisera un amplificateur opérationnel avec une entrée inverseuse et une entrée non inverseuse, identique à celui dont le gain non infini G est la cause de l'erreur qu'on veut supprimer. Il recevra à son entrée la tension de référence de conversion de l'étage précédent et il sera monté avec un réseau de résistances associées ou de capacités commutées associées tel que son gain soit égal au coefficient K représentant l'erreur introduite par l'amplificateur de l'étage précédent (K = G/(G + $2^p$ + 1)).

On utilisera de préférence pour réaliser l'amplificateur de calibration un amplification opérationnel ayant une résistance d'entrée et une résistance de rebouclage identiques de valeur R, avec une résistance de valeur R/($2^p$-1) entre les entrées inverseuse et non inverseuse de l'amplificateur opérationnel ; on utilisera un amplificateur à capacités commutées avec une capacité d'entrée et une capacité de rebouclage identiques de valeur C, et une capacité de valeur C($2^p$-1) entre les entrées inverseuse et non-inverseuse de l'amplificateur opérationnel.

D'autres caractéristiques et avantages de l'invention apparaîtront à la lecture de la description détaillée qui suit et qui est faite en référence aux dessins annexés dans lesquels:

- la figure 1 déjà décrite représente une structure de convertisseur connu avec une succession d'étages en cascade;

- la figure 2 déjà décrite représente la structure d'un étage de type connu pour le convertisseur de la figure 1;

- la figure 3 déjà décrite représente schématiquement la constitution classique d'amplificateurs à partir d'amplificateurs opérationnels;

- la figure 4 représente schématiquement la constitution selon l'invention d'un étage autre que le premier étage du convertisseur;

- la figure 5 représente un schéma d'amplificateur de calibration permettant d'engendrer une tension de référence à partir de celle de l'étage précédent;

- la figure 6 représente un schéma d'amplificateur de calibration utilisant des capacités commutées.

Selon l'invention, on propose que les étages autres que le premier étage de la structure en cascade fonctionnent à partir d'une tension de référence autre que la tension de référence Vref qui sert pour le premier étage.

Plus précisément, la tension de référence pour le premier étage est V1 = Vref

Pour le deuxième étage, la tension de référence est $V2 = V1.G/(G+2^p + 1)$

Pour le troisième étage, la tension de référence est $V3 = V2.G/(G+2^p+1)$; etc.

Chaque étage introduit une erreur en ce sens que l'amplificateur de gain théorique $2^p$ a en fait un gain plus faible. L'étage suivant utilise une tension de référence réduite dans le même rapport.

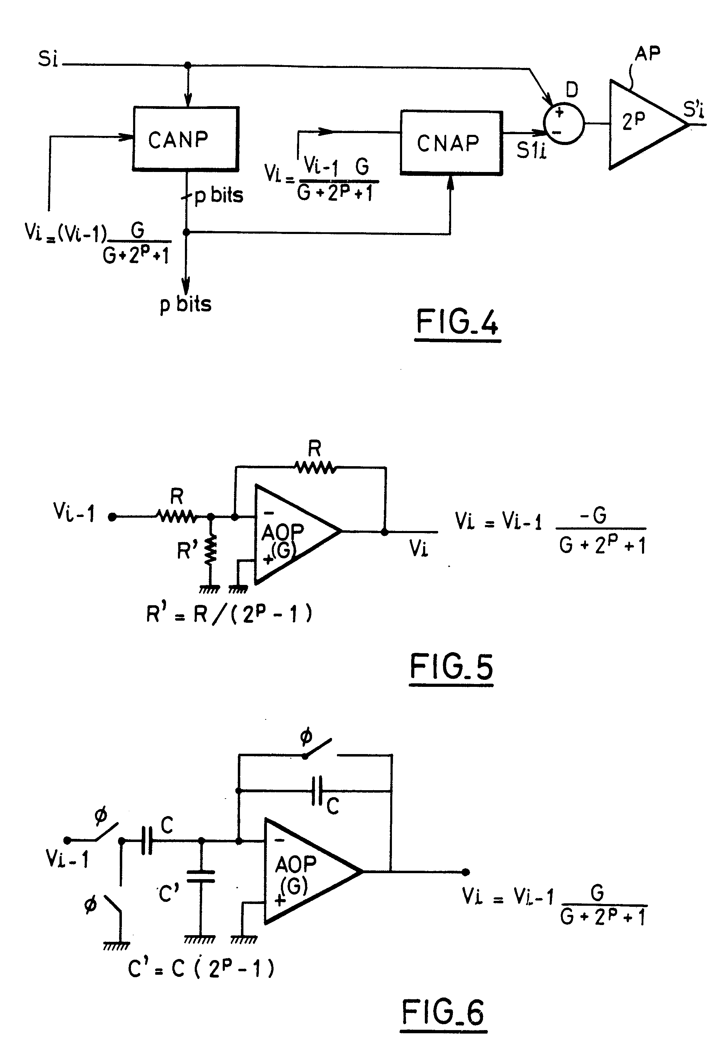

La figure 4 représente schématiquement un étage quelconque de rang i (i strictement supérieur à 1 puisque le premier étage n'est pas concerné, n'étant pas affecté par une erreur d'un étage précédent).

La seule différence avec la figure 2 réside dans le choix de la tension de référence utilisée par les convertisseurs partiels analogique-numérique (CANP) et numérique-analogique (CNAP).

On suppose que les amplificateurs opérationnels servant à réaliser les amplificateurs AP de gain $2^p$ de tous les étages sont tous identiques de sorte que le coefficient d'erreur est bien le même pour tous les étages. S'il n'en était pas ainsi, il faudrait ajuster la tension de référence utilisée pour chaque étage en fonction de l'erreur introduite par l'étage précédent. Dans la pratique, les étages sont tous identiques et l'erreur introduite est la même pour tous les étages.

La figure 5 représente un amplificateur de calibration de tension de référence servant à établir la tension de référence d'un étage à partir de la tension de référence utilisée pour l'étage précédent, cet amplificateur établissant automatiquement la correction appropriée du fait qu'il utilise un amplificateur opérationnel ayant le même gain limité G que les amplificateurs opérationnels des amplificateurs AP.

La figure 5 est un montage utilisant un amplificateur opérationnel AOP associé à des résistances. L'amplificateur opérationnel commmprend une entrée inverseuse et une entrée non-inverseuse. L'entrée inverseuse est reliée à une extrémité d'une résistance d'entrée de valeur R dont l'autre extrémité reçoit la tension de référence $V_{i-1}$ de l'étage précédent; l'entrée non-inverseuse est à la masse; une résistance de bouclage de même valeur R que la résistance d'entrée est connectée entre la sortie de l'amplificateur opérationnel et l'entrée inverseuse; enfin, une résistance R' est connectée entre l'entrée inverseuse et l'entrée non-inverseuse; elle a pour valeur $R' = R/(2^p-1)$ si le gain de l'amplificateur AP qui a causé une erreur à compenser est $2^p$.

On peut vérifier que le gain du circuit de la figure 5 est

$V_i/V_{i-1} = - G/(G+2^p+1)$

où $V_i$ est la tension de sortie du circuit, qui servira de référence pour les convertisseurs partiels de l'étage de rang i, $V_{i-1}$ est la tension de référence de l'étage précédent, G est le gain intrinsèque en boucle ouverte de l'amplificateur opérationnel AOP de la figure 5.

On établit donc une nouvelle tension de référence égale (au signe près) à celle de l'étage précédent, mais multipliée par le coefficient de correction désiré.

Le signe négatif n'est pas gênant car on peut toujours s'arranger pour en tenir compte dans les convertisseurs partiels; d'ailleurs, l'amplificateur AP inverse lui-même le signe de la tension qu'il reçoit et, par conséquent, les convertisseurs d'un étage sur deux peuvent travailler sur des tensions de signe inversés avec une tension de référence également inversée.

La figure 6 représente un circuit ayant la même fonction que celui de la figure 5 mais réalisé sous forme d'un circuit à capacités commutées.

Le circuit comprend un amplificateur opérationnel AOP identique à ceux utilisés pour les amplificateurs AP et ayant le même gain en boucle ouverte G.

L'amplificateur AOP comporte une entrée inverseuse et une entrée non-inverseuse. L'entrée inverseuse est reliée à une extrémité d'une capacité commutée d'entrée de valeur C dont l'autre extrémité reçoit la tension de référence $V_{i-1}$ de l'étage précédent; l'entrée non-inverseuse est à la masse; une capacité commutée de bouclage de même valeur C que la capacité commutée d'entrée est connectée entre la sortie de l'amplificateur opérationnel et l'entrée inverseuse; enfin, une capacité non commutée C' est connectée entre l'entrée inverseuse et l'entrée non-inverseuse; elle a pour valeur $C' = Cx(2^p-1)$ si le gain de l'amplificateur AP qui a causé une erreur à compenser est $2^p$.

On peut vérifier que le gain du circuit de la figure 5 est

$V_i/V_{i-1} = G/(G+2^p+1)$

où $V_i$ est la tension de sortie du circuit, qui servira de référence pour les convertisseurs partiels de l'étage de rang i, $V_{i-1}$ est la tension de référence de l'étage précédent, G est le gain intrinsèque en boucle ouverte de l'amplificateur opérationnel AOP de la figure 6.

On établit donc une nouvelle tension de référence égale à celle de l'étage précédent, mais multipliée par le coefficient de correction désiré.

La commutation des capacités est la suivante: dans un première phase, la capacité de rebouclage est court-circuitée et la tension de référence de l'étage précédent est appliquée aux bornes de la capacité d'entrée; dans une deuxième phase, les capacités C et C' sont mises en parallèle, déconnectées de la tension de référence de l'étage précédent, et la capacité de rebouclage est décourt-circuitée.

L'invention permet ainsi de s'affranchir de l'erreur due au gain limité des amplificateurs opérationnels. On peut donc utiliser des amplificateurs ayant un gain plus faible, de sorte que l'encombrement du circuit est plus faible et la vitesse de fonctionnement plus élevée.

Un autre avantage de l'invention, dans le cas où le convertisseur analogique-numérique est réalisé avec des capacités commutées, est le fait que la vitesse de fonctionnement peut encore être accélérée. En effet, les tensions à convertir sont appliquées sous forme échantillonnées, avec des fronts raides. Or les amplificateurs servant à la comparaison entre un signal à convertir et une tension de référence ont un temps d'établissement non négligeable. Du fait que la tension de référence de chaque étage est, elle aussi, établie par un circuit à capacités commutées (celui de la figure 6) ayant un temps d'établissement identique, on peut considérer que le résultat de la comparaison est connu avant la fin du temps d'établissement; le signal à comparer et la référence de comparaison se déplacent en effet parallèlement.

## Revendications

1. Convertisseur analogique-numérique ayant une structure à plusieurs étages (A1, A2, ..., An) en cascade, chaque étage comprenant :
- un convertisseur analogique-numérique partiel (CANP) fournissant p bits de conversion à partir d'un signal d'entrée (S),
- un convertisseur numérique-analogique partiel (CNAP) recevant ces p bits et les retransformant en signal analogique (S1),
- un soustracteur (D) effectuant la différence entre le signal appliqué à l'entrée de l'étage et le signal analogique fourni par le convertisseur numérique-analogique partiel (CNAP),
- et enfin un amplificateur de gain théorique $2^p$ amplifiant le signal de sortie du soustracteur et appliquant le signal amplifié (S') à l'étage suivant du convertisseur analogique-numérique, caractérisé en ce que chaque étage utilise comme référence de tension pour la conversion la tension de référence utilisée pour l'étage précédent multipliée par un coefficient de correction tenant compte de l'erreur de gain de l'amplificateur de gain $2^p$.

2. Convertisseur selon la revendication 1, caractérisé en ce que l'amplificateur d'un étage est réalisé à partir d'un amplificateur opérationnel à grand gain en boucle ouverte, le gain en boucle ouverte étant G, et en ce que la tension de référence de l'étage suivant est égale à la tension de référence de l'étage considéré multipliée par un coefficient égal à $G/(G+2^p+1)$.

3. Convertisseur selon l'une des revendications 1 et 2, caractérisé en ce que l'amplificateur d'un étage est réalisé à partir d'un amplificateur opérationnel à grand gain (AOP), et en ce qu'il est prévu un circuit d'établissement d'une tension de référence pour l'étage suivant, ce circuit utilisant un amplificateur opérationnel identique au premier pour permettre une prise en compte automatique des erreurs introduites par le premier amplificateur.

4. Convertisseur selon la revendication 3, caractérisé en ce qu'il comporte, pour chaque étage, un amplificateur de calibration, comprenant un amplificateur opérationnel avec une entrée inverseuse et une entrée non inverseuse, recevant à son entrée la tension de référence de conversion de l'étage précédent, et monté avec un réseau de résistances associées ou de capacités commutées associées tel que son gain soit égal au coefficient K représentant l'erreur introduite par l'amplificateur fournissant le signal de sortie de l'étage précédent.

5. Convertisseur selon la revendication 4, caractérisé en ce que l'amplificateur de calibration comprend une résistance d'entrée et une résistance de rebouclage identiques de valeur R, avec une résistance de valeur $R/(2^p-1)$ entre les entrées inverseuse et non inverseuse de l'amplificateur opérationnel.

6. Convertisseur selon la revendication 4, caractérisé en ce que l'amplificateur de calibration comporte une capacité commutée d'entrée, une capacité de rebouclage de valeur identique entre la sortie et l'entrée de l'amplificateur opérationnel, et une capacité non commutée entre l'entrée inverseuse et l'entrée non-inverseuse de l'amplificateur opérationnel.

$N = n \times p$ bits

## FIG.1

## FIG.2

$$V_s = V_e \frac{R2}{R1} \frac{-G}{G + \frac{R2}{R1} + 1}$$

$$V_s = V_e \frac{C1}{C2} \frac{G}{G + \frac{C1}{C2} + 1}$$

<u>3a</u>

<u>3b</u>

## FIG.3

$$V_i = (V_{i-1}) \frac{G}{G + 2^P + 1}$$

$$V_i = \frac{V_{i-1} \quad G}{G + 2^P + 1}$$

## FIG.4

$$V_i = V_{i-1} \frac{-G}{G + 2^P + 1}$$

$$R' = R / (2^P - 1)$$

## FIG.5

$$V_i = V_{i-1} \frac{G}{G + 2^P + 1}$$

$$C' = C (2^P - 1)$$

## FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 189 938 (CEA)<br>* Pages 14,15; figure 2; page 10, ligne 23 - page 11, ligne 31 *<br>--- | 1 | H 03 M 1/44 |
| A | FR-A-2 261 661 (MORENO)<br>* En entier *<br>----- | 1 | |

DOMAINES TECHNIQUES RECHERCHES (Int. Cl.5)

H 03 M

Le présent rapport a été établi pour toutes les revendications

| Lieu de la recherche | Date d'achèvement de la recherche | Examinateur |
|---|---|---|
| LA HAYE | 06-10-1989 | GUIVOL Y. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P0402)